# EUROPÄISCHE PATENTSCHRIFT

(11) **EP 3 200 247 B1**
(45) Veröffentlichungstag und Bekanntmachung des Hinweises auf die Patenterteilung: **05.06.2019**
(21) Anmeldenummer: 17151990.3
(22) Anmeldetag: 24.04.2008
(51) Int. Cl.: H01L 33/14, H01L 33/00

(54) **HALBLEITERCHIP UND VERFAHREN ZUR HERSTELLUNG EINES HALBLEITERCHIPS**
SEMICONDUCTOR CHIP AND METHOD FOR MANUFACTURING THE SAME
PUCE SEMI-CONDUCTRICE ET PROCÉDÉ DE FABRICATION D'UNE PUCE SEMI-CONDUCTRICE

(30) Priorität: 04.05.2007 DE 102007021389; 26.06.2007 DE 102007029370
(43) Veröffentlichungstag der Anmeldung: 02.08.2017
(62) Teilanmeldung aus: 08748776.5
(73) Patentinhaber: OSRAM Opto Semiconductors GmbH, 93055 Regensburg (DE)
(72) Erfinder: Engl, Karl, 93080 Pentling (DE); Höppel, Lutz, 93087 Alteglofsheim (DE); Eichler, Christoph, 93093 Donaustauf (DE); Sabathil, Matthias, 93059 Regensburg (DE); Weimar, Andreas, 93055 Regensburg (DE)
(74) Vertreter: Epping - Hermann - Fischer

(56) Entgegenhaltungen:
- EP-A- 1 662 584
- US-A1- 2003 141 506
- US-A1- 2006 289 886

## Beschreibung

Die Erfindung betrifft einen Halbleiterchip sowie ein Verfahren zur Herstellung eines Halbleiterchips.

LED-Halbleiterchips weisen oftmals eine hohe interne Quanteneffizienz auf. Diese gibt an, welcher Anteil von Elektron-Loch-Paaren im aktiven Bereich unter Emission von Strahlung in Form von Photonen rekombiniert. Allerdings tritt die erzeugte Strahlung meist nicht vollständig aus dem Halbleiterchip aus, sondern wird teilweise, beispielsweise aufgrund von Totalreflexion, an der Grenzfläche des Halbleiterchips in den Halbleiterchip zurückreflektiert und in diesem absorbiert. Je mehr erzeugte Photonen im Halbleiterchip aufgrund von Absorption für die nutzbare, aus dem Halbleiterchip austretende, Strahlung verloren gehen, desto geringer ist die Auskoppeleffizienz des Halbleiterchips.

Die Druckschrift US 2003/141506 A1 beschreibt ein Halbleiterelement mit einer Schutzschicht und einer Metallschicht.

In der Druckschrift US 2006/289886 A1 wird ein Bauelement mit einem Bragg-Reflektor, welcher ein Halbleitermaterial aufweist, beschrieben.

Die Druckschrift EP 1662584 A beschreibt ein strahlungsemittierendes Halbleiterbauelement mit einer elektrisch leitfähigen Zwischenschicht.

Es ist eine Aufgabe der vorliegenden Erfindung, einen Halbleiterchip anzugeben, bei dem die Auskoppeleffizienz im Betrieb des Halbleiterchips gesteigert ist. Weiterhin soll ein Verfahren angegeben werden, mit dem ein Halbleiterchip mit gesteigerter Auskoppeleffizienz vereinfacht hergestellt werden kann.

Diese Aufgaben werden durch einen Halbleiterchip gemäß Patentanspruch 1 beziehungsweise durch ein Verfahren zur Herstellung eines Halbleiterchips gemäß Patentanspruch 14 gelöst. Vorteilhafte Ausgestaltungen und Weiterbildungen der Erfindung sind Gegenstand der abhängigen Patentansprüche.

Gemäß einer Ausführungsform weist ein Halbleiterchip einen Halbleiterkörper, der eine Halbleiterschichtenfolge mit einem zur Erzeugung von Strahlung vorgesehenen aktiven Bereich umfasst, auf. Auf dem Halbleiterkörper ist eine Spiegelstruktur angeordnet. Die Spiegelstruktur weist eine Spiegelschicht und eine zumindest bereichsweise zwischen der Spiegelschicht und dem Halbleiterkörper angeordnete dielektrische Schichtstruktur auf.

Im Betrieb des Halbleiterchips im aktiven Bereich erzeugte Strahlung kann von der Spiegelstruktur in den Halbleiterkörper zurück reflektiert werden. Eine Absorption von Strahlung in vom aktiven Bereich aus gesehen der Spiegelstruktur nachgeordneten Bereichen des Halbleiterchips kann so vermieden werden. Nachfolgend kann die Strahlung aus dem Halbleiterchip austreten. Dadurch kann die Auskoppeleffizienz des Halbleiterchips gesteigert werden.

Die Spiegelschicht enthält vorzugsweise ein Metall oder eine metallische Legierung. Beispielsweise kann die Spiegelschicht Gold, Silber, Aluminium, Rhodium, Platin, Titan oder Palladium enthalten oder aus einem solchen Material bestehen. Auch eine metallische Legierung mit zumindest einem der genannten Metalle kann Anwendung finden.

In einer Ausgestaltungsvariante enthält die dielektrische Schichtstruktur genau eine dielektrische Schicht. Eine derartige dielektrische Schichtstruktur zeichnet sich insbesondere durch eine einfache Herstellbarkeit aus.

In einer alternativen Ausgestaltungsvariante weist die dielektrische Schichtstruktur eine Mehrzahl von dielektrischen Schichten auf. Mittels der dielektrischen Schichten kann eine dielektrische Spiegelstruktur gebildet sein. Insbesondere kann die dielektrische Spiegelstruktur als Bragg-Spiegel ausgebildet sein. Mit einer solchen dielektrischen Spiegelstruktur sind hohe Reflektivitäten für im aktiven Bereich erzeugte Strahlung erzielbar.

Strahlung, die in einem Winkel auf die dielektrische Schichtstruktur auftritt, in dem die Reflektivität der dielektrischen Schichtstruktur vergleichsweise gering ist, kann durch die dielektrische Schichtstruktur hindurch treten und nachfolgend an der Spiegelschicht reflektiert werden.

Insbesondere im Vergleich zur dielektrischen Spiegelstruktur weist die Reflektivität der, vorzugsweise metallischen oder auf einer metallischen Legierung basierenden, Spiegelschicht eine vergleichsweise geringe Abhängigkeit vom Auftreffwinkel der Strahlung auf. Durch die Kombination der dielektrischen Schichtstruktur mit der Spiegelschicht kann somit ein besonders hoher Anteil von auf die Spiegelstruktur auftreffender Strahlung an dieser reflektiert werden. Die Reflektivität der Spiegelstruktur für im aktiven Bereich erzeugte Strahlung kann 80 % oder mehr, bevorzugt 90% oder mehr, besonders bevorzugt 95% oder mehr, betragen.

Zumindest eine Schicht der dielektrischen Schichtstruktur enthält bevorzugt ein Oxid, etwa SiO₂, ein Nitrid, etwa Si₃N₄, oder ein Oxinitrid, etwa SiON.

Der Halbleiterkörper kann eine Seitenfläche aufweisen, die den Halbleiterkörper, insbesondere den aktiven Bereich, in lateraler Richtung begrenzt. Unter einer lateralen Richtung wird hierbei eine Richtung verstanden, die entlang einer Haupterstreckungsrichtung der Schichten der Halbleiterschichtenfolge verläuft. Die Seitenfläche erstreckt sich vorzugsweise senkrecht oder schräg zur Haupterstreckungsrichtung der Schichten der Halbleiterschichtenfolge.

In einer bevorzugten Ausgestaltung erstreckt sich die Spiegelstruktur, insbesondere die dielektrische Schichtstruktur, zumindest bereichsweise bis zu der den Halbleiterkörper begrenzenden Seitenfläche des Halbleiterkörpers. Insbesondere kann sich die Spiegelstruktur über den gesamten Umfang des Halbleiterkörpers in lateraler Richtung bis zu der Seitenfläche oder gegebenenfalls bis zu weiteren, jeweils den Halbleiterkörper begrenzenden, Seitenflächen des Halbleiterkörpers erstrecken.

Weitergehend kann sich die Spiegelstruktur, insbesondere dielektrische Schichtstruktur, in lateraler Richtung zumindest bereichsweise über die den Halbleiterkörper begrenzende Seitenfläche hinaus, insbesondere eben, fortsetzen. Weiterhin bevorzugt ist die den Halbleiterkörper begrenzende Seitenfläche frei von Material für die dielektrische Schichtstruktur.

Auch die Spiegelschicht kann sich in lateraler Richtung zumindest bereichsweise über die den Halbleiterkörper begrenzende Seitenfläche hinaus, insbesondere eben, fortsetzen.

Auf dem Halbleiterkörper ist eine Kontaktstruktur angeordnet. Die Kontaktstruktur kann auf derselben Seite des Halbleiterkörpers angeordnet sein wie die dielektrische Schichtstruktur. Die Kontaktstruktur dient der externen elektrischen Kontaktierung des Halbleiterchips.

Weiterhin bevorzugt weist der Halbleiterchip eine weitere Kontaktstruktur auf. Insbesondere kann die weitere Kontaktstruktur auf der der Kontaktstruktur abgewandten Seite des aktiven Bereichs auf dem Halbleiterkörper angeordnet sein. Mittels dieser Kontaktstrukturen können im Betrieb des Halbleiterchips Ladungsträger in den Halbleiterkörper injiziert werden.

Der Halbleiterchip weist vorzugsweise eine Strahlungsaustrittsfläche auf, die sich in lateraler Richtung erstreckt. Die Spiegelstruktur, insbesondere die dielektrische Schichtstruktur, ist vorzugsweise auf der der Strahlungsaustrittsfläche abgewandten Seite des aktiven Bereichs angeordnet. Im aktiven Bereich erzeugte und in Richtung der Spiegelschicht abgestrahlte Strahlung kann mittels der dielektrischen Schichtstruktur in Richtung der Strahlungsaustrittsfläche reflektiert werden und schließlich durch diese Strahlungsaustrittsfläche austreten.

In einer weiteren bevorzugten Ausgestaltung weist der Halbleiterchip einen Träger auf, auf dem der Halbleiterkörper angeordnet ist. Der Träger ist also Teil des Halbleiterchips und dient insbesondere der mechanischen Stabilisierung des Halbleiterkörpers. Weiterhin kann der Träger von einem Aufwachssubstrat für die Halbleiterschichtenfolge verschieden sein. Der Träger muss daher nicht die hohen Anforderungen an die Kristallinität eines Aufwachssubstrats erfüllen, sondern kann vielmehr im Hinblick auf andere physikalische Eigenschaften, etwa eine hohe thermische Leitfähigkeit oder eine hohe mechanische Stabilität, ausgewählt werden. Beispielsweise kann der Träger Silizium, Siliziumkarbid, Germanium, Galliumarsenid, Galliumnitrid, Galliumphosphid oder ein anderes Halbleitermaterial enthalten oder aus einem solchen Material bestehen. Die elektrische Leitfähigkeit eines solchen Trägers kann beispielsweise mittels Dotierung gesteigert sein. Auch ein elektrisch isolierender Träger, etwa ein Träger der Aluminiumnitrid oder Saphir enthält oder aus einem solchen Material besteht, kann Anwendung finden. Der Träger kann mittels einer Verbindungsschicht an dem Halbleiterkörper befestigt sein. Beispielsweise kann die Verbindungsschicht ein Lot oder einen Kleber enthalten.

Alternativ kann der Träger mittels einer Schicht gebildet sein, die auf dem Halbleiterkörper abgeschieden ist. Hierbei ist die Schicht hinreichend dick, um den Halbleiterkörper mechanisch zu stabilisieren. Der Träger kann beispielsweise mittels einer metallischen oder einer auf einer metallischen Legierung basierenden Schicht gebildet sein.

Der Träger ist bevorzugt auf der der Strahlungsaustrittsfläche abgewandten Seite des Halbleiterkörpers angeordnet. Weiterhin ist die Spiegelstruktur vorzugsweise zwischen dem Träger und dem Halbleiterkörper angeordnet. Im aktiven Bereich erzeugte und in Richtung des Trägers abgestrahlte Strahlung kann so an der Spiegelstruktur in Richtung der Strahlungsaustrittsfläche reflektiert werden und schließlich durch diese Strahlungsaustrittsfläche austreten.

In einer bevorzugten Weiterbildung ragt der Träger in Aufsicht auf den Halbleiterchip zumindest bereichsweise über den Halbleiterkörper hinaus. In diesem Fall kann sich die Spiegelstruktur, insbesondere die dielektrische Schichtstruktur, über die Seitenfläche des Halbleiterkörpers hinaus bis zu einer den Träger begrenzenden Seitenfläche des Trägers erstrecken. Die Spiegelstruktur, insbesondere die dielektrische Schichtstruktur, kann sich also parallel zum Träger über die Seitenfläche des Halbleiterchips hinaus erstrecken. Auch durch die Seitenfläche des Halbleiterkörpers in Richtung des Trägers austretende Strahlung kann so von der Spiegelstruktur reflektiert werden. Absorption von im aktiven Bereich erzeugter Strahlung im Träger kann also besonders effizient vermindert werden.

In einer bevorzugten Ausgestaltung ist die Kontaktstruktur mittels der Spiegelschicht gebildet. Die Spiegelschicht kann also sowohl der elektrischen Kontaktierung des Halbleiterkörpers als auch einer Verspiegelung der dielektrischen Schichtstruktur dienen. Hierbei kann sich die Spiegelschicht vollständig oder nur bereichsweise über eine, vorzugsweise dem Träger zugewandte, Oberfläche des Halbleiterkörpers erstrecken.

Die dielektrische Schichtstruktur weist eine Aussparung auf. Die Kontaktstruktur ist in dieser zumindest einen Aussparung der dielektrischen Schichtstruktur ausgebildet. Weitergehend kann die dielektrische Schichtstruktur mittels der Aussparung in zumindest zwei separate Teilbereiche geteilt sein. Die Aussparung kann also zwischen den separaten Teilbereichen ausgebildet sein. Beispielsweise kann die dielektrische Schichtstruktur einen inneren Teilbereich und einen äußeren Teilbereich aufweisen, wobei der äußere Teilbereich den inneren Teilbereich in lateraler Richtung vollständig umlaufen kann. In diesem Fall kann der äußere Teilbereich rahmenartig ausgebildet sein.

In einer weiteren bevorzugten Ausgestaltung sind die dielektrische Schichtstruktur und die Kontaktstruktur zumindest bereichsweise nebeneinander angeordnet. Im Betrieb des Halbleiterchips werden Ladungsträger in einem an die Kontaktstruktur angrenzenden Bereich des Halbleiterkörpers in den Halbleiterkörper injiziert. An Stellen des Halbleiterkörpers, die an die dielektrische Schichtstruktur angrenzen, werden dagegen keine Ladungsträger injiziert. Mittels der dielektrischen Schichtstruktur kann also in lateraler Richtung zumindest ein Bereich der Oberfläche des Halbleiterkörpers definiert sein, über den im Betrieb des Halbleiterchips keine Ladungsträger in den Halbleiterkörper injiziert werden.

Beispielsweise kann die dielektrische Schichtstruktur, insbesondere der innere Teilbereich der dielektrischen Schichtstruktur, in einer Aufsicht auf den Halbleiterchip mit einem Bereich der Strahlungsaustrittsfläche überlappen, der, beispielsweise durch die weitere Kontaktstruktur, abgeschattet ist. Die weitere Kontaktstruktur und die dielektrische Schichtstruktur können in einer Aufsicht auf den Halbleiterchip also überlappen. Der innere Teilbereich der dielektrischen Schichtstruktur kann hierbei in seiner lateralen Formgebung an die Form der weiteren Kontaktstruktur angepasst sein. Der Anteil von Strahlung, der unterhalb der weiteren Kontaktstruktur erzeugt und von dieser absorbiert wird, kann so vermindert werden.

Weiterhin kann die dielektrische Schichtstruktur in lateraler Richtung derart ausgebildet sein, etwa durch eine rahmenartige Ausbildung der dielektrischen Schichtstruktur beziehungsweise des äußeren Teilbereichs der dielektrischen Schichtstruktur, dass die Injektion von Ladungsträgern im Randbereich des Halbleiterkörpers, also nahe der Seitenfläche des Halbleiterkörpers, vermindert ist. Auf diese Weise kann die nicht-strahlende Rekombination von Ladungsträgern im Halbleiterkörper verringert werden.

In einer weiteren bevorzugten Ausgestaltung ist zwischen der Spiegelschicht und dem Halbleiterkörper durchgehend die dielektrische Schichtstruktur angeordnet.

Weiterhin bevorzugt weist die Spiegelschicht eine Aussparung auf, wobei die Aussparung der Spiegelschicht mit der Aussparung der dielektrischen Schichtstruktur überlappt. In diesem Fall können die Kontaktstruktur und die Spiegelschicht voneinander beabstandet ausgebildet sein.

Die Kontaktstruktur und/oder die weitere Kontaktstruktur kann mehrschichtig ausgebildet sein. Insbesondere kann zumindest eine Schicht der Kontaktstruktur beziehungsweise der weiteren Kontaktstruktur ein TCO-Material (transparent conductive oxide, kurz "TCO") enthalten. Bevorzugt grenzt eine TCO-Material enthaltende Schicht an den Halbleiterkörper an. TCO-Materialien sind transparente, leitende Materialien, in der Regel Metalloxide, wie beispielsweise Zinkoxid, Zinnoxid, Cadmiumoxid, Titanoxid, Indiumoxid oder Indiumzinnoxid (ITO). Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung. Die TCOs können auch p- oder n-dotiert sein.

Weiterhin kann die Kontaktstruktur eine Reflektorschicht aufweisen. Die Reflektorschicht ist vorzugsweise näher am Halbleiterkörper angeordnet als die Spiegelschicht. Die Reflektorschicht kann an den Halbleiterkörper angrenzen. Alternativ kann die TCO-Material enthaltende Schicht der Kontaktstruktur zwischen der Reflektorschicht und dem Halbleiterkörper angeordnet sein.

Entsprechend kann die weitere Kontaktstruktur eine weitere Reflektorschicht aufweisen. Die weitere Reflektorschicht ist vorzugsweise zwischen dem Halbleiterkörper und einer Anschluss-Schicht der weiteren Kontaktstruktur angeordnet. Die Anschluss-Schicht ist zur externen elektrischen Kontaktierung des Halbleiterchips, beispielsweise mittels eines Bond-Drahts, vorgesehen.

An der Reflektorschicht beziehungsweise an der weiteren Reflektorschicht kann im aktiven Bereich des Halbleiterchips erzeugte Strahlung in den Halbleiterkörper zurück reflektiert werden. Eine Absorption von Strahlung in einer vom aktiven Bereich aus gesehen der Reflektorschicht beziehungsweise der weiteren Reflektorschicht nachgeordneten Schicht der Kontaktstruktur beziehungsweise der weiteren Kontaktstruktur kann so vermieden oder zumindest vermindert werden.

Insbesondere können die Reflektorschicht und/oder die weitere Reflektorschicht ein Metall oder eine metallische Legierung enthalten. Beispielsweise eignen sich Gold, Silber, Aluminium, Rhodium, Platin, Titan, Palladium oder eine Legierung mit zumindest einem dieser Materialien.

Insbesondere für den Fall, dass die Reflektorschicht und/oder die weitere Reflektorschicht an den Halbleiterkörper angrenzt, weist die Reflektorschicht beziehungsweise die weitere Reflektorschicht vorzugsweise neben einer hohen Reflektivität für im aktiven Bereich erzeugte Strahlung auch gute elektrische Kontakteigenschaften zum Halbleiterkörper auf.

Falls die Reflektorschicht und/oder die weitere Reflektorschicht vom Halbleiterkörper beabstandet sind, kann die Reflektorschicht beziehungsweise die weitere Reflektorschicht wie die Spiegelschicht überwiegend in Hinblick auf eine möglichst hohe Reflektivität für im aktiven Bereich erzeugte Strahlung ausgebildet ist.

Auf der dem Halbleiterkörper abgewandten Seite der Reflektorschicht kann die Spiegelschicht ausgebildet sein. Hierbei kann sich die Spiegelschicht vollständig oder nur bereichsweise über die Reflektorschicht erstrecken.

In einer bevorzugten Ausgestaltung weist der Halbleiterkörper eine, vorzugsweise an die Kontaktstruktur oder an die weitere Kontaktstruktur angrenzende, Tunnelkontaktschicht auf. Die Tunnelkontaktschicht ist vorzugsweise stark p-leitend oder stark n-leitend dotiert. Weiterhin weist die Tunnelkontaktschicht einen anderen Leitungstyp auf als eine andere zwischen dem aktiven Bereich und der Kontaktstruktur beziehungsweise der weiteren Kontaktstruktur angeordnete Halbleiterschicht. Mittels der Tunnelkontaktschicht können Ladungsträger im Betrieb des Halbleiterchips vereinfacht in den Halbleiterkörper injiziert werden.

In einer weiteren bevorzugten Ausgestaltung ist die Oberfläche des Halbleiterkörpers, auf dem die weitere Kontaktstruktur angeordnet ist, in einem in vertikaler Richtung an die weitere Kontaktstruktur angrenzenden Bereich eben. In diesem Bereich ist die Oberfläche des Halbleiterkörpers vorzugsweise geglättet. Je geringer die Rauhigkeit dieses Bereichs der Oberfläche ist, desto kann die Reflektivität der Kontaktstruktur sein.

Weiterhin bevorzugt weist die Oberfläche in einem lateral an den ebenen Bereich angrenzenden weiteren Bereich eine Strukturierung auf. Die Strukturierung ist zur Steigerung der Auskoppeleffizienz von im aktiven Bereich erzeugter Strahlung aus dem Halbleiterkörper vorgesehen. Die Strukturierung kann regelmäßig oder unregelmäßig ausgebildet sein.

Eine unregelmäßige Strukturierung kann beispielsweise mittels Aufrauens der Oberfläche hergestellt sein. Alternativ kann die Strukturierung regelmäßig, beispielsweise in Form von Mikroprismen oder in Form eines photonischen Gitters ausgebildet sein. Bei einem photonischen Gitter liegt eine Periodenlänge der lateralen Strukturierung, also die Länge, nach der sich die laterale Strukturierung periodisch wiederholt, im Bereich der Wellenlänge der im aktiven Bereich erzeugten Strahlung, etwa zwischen dem 0,1-fachen und dem 10-fachen dieser Wellenlänge in dem Material, in dem das photonische Gitter ausgebildet ist.

In einer weiteren bevorzugten Ausgestaltung ist das Aufwachssubstrat für die Halbleiterschichtenfolge zumindest bereichsweise entfernt oder zumindest bereichsweise gedünnt. Ein derartiger Halbleiterchip wird auch als Dünnfilm-Halbleiterchip bezeichnet.

Ein strahlungserzeugender Dünnfilm-Halbleiterchip kann sich insbesondere durch folgende charakteristische Merkmale auszeichnen:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Der Halbleiterchip ist bevorzugt zur Erzeugung von überwiegend inkohärenter Strahlung vorgesehen. Beispielsweise kann der Halbleiterchip als ein LED-Chip oder weitergehend als RCLED-Chip (Resonant Cavity Light Emitting Diode) ausgeführt sein. Bei einer RCLED ist der aktive Bereich innerhalb einer Kavität angeordnet. Alternativ kann der Halbleiterchip zur Erzeugung von kohärenter Strahlung vorgesehen sein. In diesem Fall kann der Halbleiterchip als ein Halbleiterlaserchip, insbesondere als ein oberflächenemittierender Halbleiterlaserchip mit internem Resonator (vertical cavity surface emitting laser, VCSEL) oder als oberflächenemittierender Halbleiterchip zum Betrieb mit einem externen Resonator (vertical external cavity surface emitting laser, VECSEL) ausgeführt sein.

Der Halbleiterkörper, insbesondere der aktive Bereich, enthält bevorzugt ein III-V-Halbleitermaterial. III-V-Halbleitermaterialien sind zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y} As) Spektralbereich besonders geeignet. Hierbei gilt jeweils 0 ≤ x ≤ 1, 0 ≤ y ≤ 1 und x + y ≤ 1, bevorzugt mit x ≠ 0, y ≠ 0, x ≠ 1 und/oder y ≠ 1. Mit III-V-Halbleitermaterialien, insbesondere aus den genannten Materialsystemen, können weiterhin bei der Strahlungserzeugung vorteilhaft hohe interne Quanteneffizienzen erzielt werden.

Gemäß einer Ausführungsform wird bei einem Verfahren zur Herstellung eines Halbleiterchips mit jeweils einem Halbleiterkörper, der eine Halbleiterschichtenfolge mit einem zur Erzeugung von Strahlung vorgesehenen aktiven Bereich umfasst, zunächst ein Halbleiterschichtstruktursystem mit dem aktiven Bereich bereitgestellt. Der Halbleiterkörper mit der Halbleiterschichtenfolge geht während des Herstellungsverfahrens aus dem Halbleiterschichtstruktursystem hervor.

Auf dem vorgefertigten Halbleiterschichtstruktursystem wird eine Spiegelstruktur ausgebildet, wobei die Spiegelstruktur eine dielektrische Schichtstruktur und eine Spiegelschicht umfasst. Aus dem Halbleiterschichtstruktursystem wird der Halbleiterkörper mit der Halbleiterschichtenfolge ausgebildet. Der Halbleiterchip wird fertig gestellt.

Auf diese Weise ist ein Halbleiterchip, der eine Spiegelstruktur umfasst, vereinfacht herstellbar.

Vorzugsweise erfolgt das Ausbilden des Halbleiterkörpers aus dem Halbleiterschichtstruktursystem nach dem Ausbilden der Spiegelstruktur.

Das Halbleiterschichtstruktursystem wird bevorzugt auf einem Aufwachssubstrat für das Halbleiterschichtstruktursystem bereitgestellt. Hierbei sind die Halbleiterschichten des Halbleiterschichtstruktursystems bevorzugt epitaktisch, insbesondere mittels MBE oder MOVPE, auf dem Aufwachssubstrat abgeschieden.

In einer bevorzugten Ausgestaltung wird das Halbleiterschichtstruktursystem, insbesondere vor dem Ausbilden des Halbleiterkörpers aus dem Halbleiterschichtstruktursystem, auf einem Träger befestigt. Der Träger dient insbesondere der mechanischen Stabilisierung des Halbleiterkörpers. Das Aufwachssubstrat ist für eine gleich bleibend gute mechanische Stabilisierung also nicht mehr erforderlich. Alternativ kann der Träger auf dem Halbleiterschichtstruktursystem abgeschieden werden. Diese kann beispielsweise galvanisch oder mittels eines anderen Abscheideverfahrens, etwa mittels Aufdampfens oder Aufsputterns, erfolgen.

In einer bevorzugten Weiterbildung wird das Aufwachssubstrat für das Halbleiterschichtstruktursystem zumindest bereichsweise entfernt oder zumindest bereichsweise gedünnt. Dies kann beispielsweise mittels eines mechanischen Prozesses, etwa mittels Schleifens, Glättens oder Polierens, erfolgen. Auch ein chemischer Prozess, insbesondere ein Ätzprozess, kann Anwendung finden. Für ein Entfernen des Aufwachssubstrats kann alternativ oder zusätzlich ein Laserablöseverfahren eingesetzt werden. Das Aufwachssubstrat wird vorzugsweise entfernt oder gedünnt, nachdem der Träger vorgesehen wurde.

In einer weiteren bevorzugten Ausgestaltung wird auf dem Halbleiterkörper eine Kontaktstruktur ausgebildet. Zusätzlich kann eine weitere Kontaktstruktur ausgebildet werden. Die Kontaktstruktur sowie gegebenenfalls die weitere Kontaktstruktur können einschichtig oder mehrschichtig ausgebildet sein. Die Schicht beziehungsweise die Mehrzahl von Schichten der Kontaktstrukturen können beispielsweise mittels Aufdampfens oder Sputterns abgeschieden werden.

In einer bevorzugten Weiterbildung wird eine Oberfläche des Halbleiterkörpers zumindest bereichsweise geglättet, wobei die Kontaktstruktur und/oder die weitere Kontaktstruktur nachfolgend auf dem geglätteten Bereich der Oberfläche ausgebildet werden. Die Reflektivität der Kontaktstruktur beziehungsweise der weiteren Kontaktstruktur kann so gesteigert werden. Auf die Kontaktstruktur beziehungsweise die weitere Kontaktstruktur auftreffende Strahlung kann so effizient in den Halbleiterkörper zurückreflektiert werden und nachfolgend aus diesem austreten.

Das Glätten des Halbleiterkörpers erfolgt vorzugsweise mechanisch, insbesondere mittels Schleifens, Läppens oder Polierens. Alternativ oder ergänzend kann das Glätten auch chemisch, beispielsweise in einem nasschemischen oder trockenchemischen Prozess, erfolgen.

In einer weiteren bevorzugten Ausgestaltung wird eine Oberfläche des Halbleiterkörpers mit einer Strukturierung versehen. Ein Bereich der Oberfläche, auf dem die Kontaktstruktur beziehungsweise die weitere Kontaktstruktur ausgebildet wird, wird bei der Strukturierung vorzugsweise ausgespart. Die Strukturierung ist zur Steigerung der Auskoppeleffizienz des Halbleiterchips vorgesehen. Die Strukturierung kann vor oder nach dem Ausbilden des Halbleiterkörpers aus dem Halbleiterschichtstruktursystem erfolgen. Beispielsweise kann die Strukturierung mittels mechanischen Aufrauens der Oberfläche hergestellt werden. Eine, insbesondere regelmäßige, Strukturierung, etwa in Form von Mikroprismen oder in Form eines photonischen Kristalls, kann beispielsweise chemisch, insbesondere mittels nasschemischen oder trockenchemischen Ätzens, hergestellt werden.

Das beschriebene Verfahren zur Herstellung eines Halbleiterchips ist zur Herstellung eines weiter oben beschriebenen Halbleiterchips besonders geeignet. Im Zusammenhang mit dem Halbleiterchip beschriebene Merkmale können daher auch für das Verfahren herangezogen werden und umgekehrt.

Weitere Merkmale, vorteilhafte Ausgestaltungen und Zweckmäßigkeiten der Erfindung ergeben sich aus der folgenden Beschreibung von Beispielen und Ausführungsbeispielen in Verbindung mit den Figuren.

Es zeigen:
- Figuren 1A und 1B: ein erstes Beispiel für einen Halbleiterchip in schematischer Schnittansicht in Figur 1A und in schematischer Aufsicht in Figur 1B,
- Figur 2: ein zweites Beispiel für einen Halbleiterchip in schematischer Schnittansicht,
- Figur 3: ein drittes Beispiel für einen Halbleiterchip in schematischer Schnittansicht,
- Figur 4: ein erstes Ausführungsbeispiel für einen erfindungsgemäßen Halbleiterchip in schematischer Schnittansicht,
- Figur 5: ein viertes Beispiel für einen Halbleiterchip in schematischer Schnittansicht,
- Figur 6: ein fünftes Beispiel für einen Halbleiterchip in schematischer Schnittansicht, und
- Figuren 7A bis 7D: ein Beispiel für ein Verfahren anhand von schematisch in Schnittansichten dargestellten Zwischenschritten.

Gleiche, gleichartige und gleich wirkende Elemente sind in den Figuren mit gleichen Bezugszeichen versehen.

Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

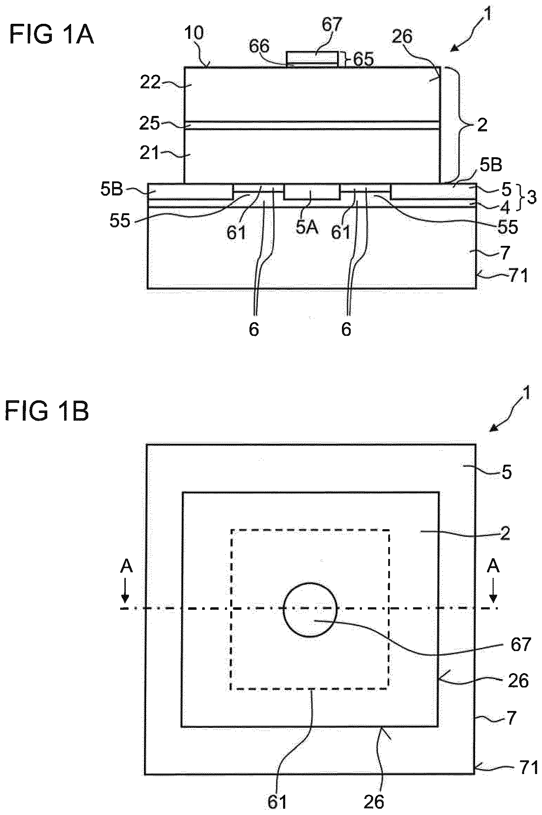

Ein erstes Beispiel für einen Halbleiterchip, welches kein Ausführungsbeispiel ist, ist in Figur 1A in schematischer Schnittansicht entlang der in der zugehörigen Aufsicht (Figur 1B) dargestellten Schnittlinie A-A gezeigt.

Der Halbleiterchip 1 weist eine Halbleiterschichtenfolge auf, die den Halbleiterkörper 2 bildet. Die Halbleiterschichtenfolge ist vorzugsweise epitaktisch, etwa mittels MOVPE oder MBE, auf einem Aufwachssubstrat abgeschieden. Die Halbleiterschichtenfolge des Halbleiterkörpers 2 umfasst einen aktiven Bereich 25. Der aktive Bereich ist zwischen einer p-leitenden Schicht 21 und einer n-leitenden Schicht 22 der Halbleiterschichtenfolge angeordnet. Auf dem Halbleiterkörper ist eine Spiegelstruktur 3 ausgebildet, die eine Spiegelschicht 4 und eine dielektrische Schichtstruktur 5 aufweist. Die p-leitende Schicht 21 ist exemplarisch auf der der Spiegelstruktur zugewandten Seite des aktiven Bereichs ausgebildet. Entsprechend ist die n-leitende Schicht 21 auf der der Spiegelstruktur 3 abgewandten Seite des aktiven Bereichs 25 ausgebildet. Davon abweichend ist auch eine Anordnung möglich, bei der die n-leitende und die p-leitende Schicht vertauscht sind.

Der Halbleiterchip 1 umfasst einen Träger 7, auf dem der Halbleiterkörper 2 angeordnet ist. Der Träger ist insbesondere von einem Aufwachssubstrat für die Halbleiterschichtenfolge des Halbleiterkörpers 2 verschieden. Er muss daher nicht die hohen Anforderungen an ein Aufwachssubstrat, insbesondere hinsichtlich der kristallinen Reinheit, erfüllen. Vielmehr kann der Träger nach anderen physikalischen Eigenschaften, etwa hinsichtlich einer hohen mechanischen Stabilität oder einer hohen thermischen Leitfähigkeit, gewählt werden. Der Halbleiterkörper 2 kann beispielsweise mittels einer Verbindungsschicht an dem Träger befestigt sein (nicht explizit dargestellt). Die Verbindungsschicht kann beispielsweise ein Lot oder einen, vorzugsweise elektrisch leitfähigen, Kleber enthalten. Der Träger kann beispielsweise einen Halbleiter, etwa Silizium, Siliziumkarbid, Galliumarsenid, Galliumnitrid oder Germanium enthalten oder aus einem solchen Material bestehen. Der Träger kann elektrisch leitfähig ausgeführt sein. In diesem Fall kann die externe Kontaktierung des Halbleiterchips durch das Trägermaterial hindurch erfolgen. Auch ein elektrisch isolierender Träger, etwa ein Träger, der Saphir oder AlN enthält oder aus einem solchen Material besteht, kann Anwendung finden.
Alternativ zum Befestigen des Halbleiterkörpers 2 an einem vorgefertigten Trägerkörper kann der Träger 7 auf dem Halbleiterkörper 2 abgeschieden sein. Hierbei ist der Träger vorzugsweise hinreichend dick abgeschieden, um den Halbleiterkörper 2 mit der Halbleiterschichtenfolge mechanisch zu stabilisieren. In diesem Fall kann auf eine Verbindungsschicht zwischen dem Halbleiterkörper 2 und dem Träger 7 verzichtet werden. Ein solcher auf dem Halbleiterkörper 2 mit der Halbleiterschichtenfolge ausgebildeter Träger kann beispielsweise mittels Galvanisierens, Sputterns oder Aufdampfens, hergestellt sein.

In Aufsicht auf den Halbleiterchip 1 weist der Träger 7 eine größere laterale Ausdehnung auf als der Halbleiterkörper 2. Der Halbleiterkörper 2 bedeckt den Träger also nur bereichsweise.

Die dielektrische Schichtstruktur 5 enthält vorzugsweise ein Oxid, etwa SiO₂, ein Nitrid, etwa Si₃N₄, oder ein Oxinitrid, etwa SiON.

Die Spiegelstruktur 3 ist zwischen dem Träger 7 und dem Halbleiterkörper 2 mit der Halbleiterschichtenfolge angeordnet. Die dielektrische Schichtstruktur 5 und die Spiegelschicht 4 sind somit auf der dem Träger 7 zugewandten Seite des Halbleiterkörpers 2 angeordnet. Eine Strahlungsaustrittsfläche 10 des Halbleiterchips ist auf der dem Träger gegenüberliegenden Seite des Halbleiterkörpers ausgebildet. Die dielektrische Schichtstruktur ist zumindest in einem Bereich zwischen dem Halbleiterkörper 2 und der Spiegelschicht 4 angeordnet.

Weiterhin ist zwischen dem Halbleiterkörper 2 und dem Träger 7 eine Kontaktstruktur 6 angeordnet. Die Kontaktstruktur 6 und die dielektrische Schichtstruktur 5 sind nebeneinander angeordnet. Die dielektrische Schichtstruktur weist eine Aussparung 55 auf, in der die Kontaktstruktur 6 ausgebildet ist. Die Kontaktstruktur 6 erstreckt sich durch die Aussparung 55 hindurch.

Die dielektrische Schichtstruktur 5 weist einen inneren Teilbereich 5A und einen äußeren Teilbereich 5B auf. Der äußere Teilbereich umläuft den inneren Teilbereich in lateraler Richtung, wobei der innere Teilbereich und der äußere Teilbereich mittels der Aussparung 55 voneinander getrennt sind. Die Aussparung verläuft also zwischen dem inneren Teilbereich und dem äußeren Teilbereich. Der äußere Teilbereich 5B ist rahmenartig ausgebildet und verläuft in Aufsicht auf den Halbleiterchip entlang einer lateralen Begrenzung des Halbleiterkörpers 2. Mittels des äußeren Teilbereichs 5B der dielektrischen Schichtstruktur 5 wird im Betrieb des Halbleiterchips 1 die Injektion von Ladungsträgern nahe der lateralen Begrenzung des Halbleiterkörpers vermindert. Nicht-strahlende Rekombination von Ladungsträgern am Rand, beispielsweise an der Seitenfläche 26, kann so vermindert werden. Dadurch kann die insgesamt aus dem Halbleiterchip 1 austretende Strahlungsleistung gesteigert werden.

Die Kontaktstruktur 6 ist mittels der Spiegelschicht 4 und einer Reflektorschicht 61 gebildet. Die Reflektorschicht 61 ist auf der dem Halbleiterkörper zugewandten Seite der Spiegelschicht ausgebildet. Die Reflektorschicht ist also näher am Halbleiterkörper 2 als die Spiegelschicht. Weiterhin grenzt die Reflektorschicht an den Halbleiterkörper an. Im aktiven Bereich 25 erzeugte Strahlung kann an dieser Reflektorschicht in den Halbleiterkörper zurück reflektiert werden und nachfolgend, insbesondere durch die Strahlungsaustrittsfläche 10, aus dem Halbleiterchip 1 austreten. Ferner kann in Richtung des Trägers 7 abgestrahlte Strahlung, insbesondere in Randbereichen des Halbleiterkörpers 2, von der Spiegelstruktur 4, insbesondere von der Spiegelschicht 3, reflektiert werden. Absorption von Strahlung im Träger kann so vermieden oder zumindest stark vermindert werden.

Auf der dem Träger 7 abgewandten Seite des Halbleiterkörpers 2 ist eine weitere Kontaktstruktur 65 ausgebildet. Die weitere Kontaktstruktur umfasst eine weitere Reflektorschicht 66 und eine Anschluss-Schicht 67. Die weitere Reflektorschicht ist zwischen der Anschluss-Schicht 67 und dem Halbleiterkörper 2 angeordnet. Mittels der weiteren Reflektorschicht 66 kann einer Absorption von Strahlung in der Anschluss-Schicht 67 vorgebeugt werden. Die weitere Kontaktstruktur 65, insbesondere die Anschluss-Schicht 67, ist zur externen elektrischen Kontaktierung des Halbleiterchips, beispielsweise mittels eines Bond-Drahts, vorgesehen. Die Anschluss-Schicht enthält bevorzugt ein Metall oder eine metallische Legierung, besonders bevorzugt Gold.

In einer Aufsicht auf den Halbleiterchip überdecken sich die weitere Kontaktstruktur 65 und der innere Teilbereich 5A der dielektrischen Schichtstruktur 5, insbesondere gegenseitig. Hinsichtlich der lateralen Formgebung ist also der innere Teilbereich der dielektrischen Schichtstruktur an diejenige der weiteren Kontaktstruktur 65 angepasst. Mittels der dielektrischen Schichtstruktur 5 ist so im Betrieb des Halbleiterchips die Einprägung von Ladungsträgern in den Halbleiterkörper 2 derart geführt, dass im aktiven Bereich 25 Strahlung überwiegend in lateralen Bereichen erzeugt wird, in denen die Strahlungsaustrittsfläche 10 nicht von der weiteren Kontaktstruktur 65 abgeschattet ist.

Die Spiegelschicht enthält bevorzugt ein Metall oder eine metallische Legierung oder besteht aus einem solchen Material. Besonders bevorzugt enthält die Spiegelschicht Palladium, Platin, Nickel, Gold, Silber, Aluminium, Rhodium, Titan oder eine Legierung mit zumindest einem dieser Materialien. Gold zeichnet sich beispielsweise im Infraroten durch eine hohe Reflektivität aus. Palladium, Aluminium, Silber und Rhodium sowie metallische Legierungen mit zumindest einem dieser Materialien sind für den sichtbaren und den ultravioletten Spektralbereich besonders geeignet. Die Reflektivität der Spiegelstruktur 3 für im aktiven Bereich erzeugte Strahlung beträgt bevorzugt 80 % oder mehr, besonders bevorzugt 90% oder mehr, beispielsweise 95% oder mehr.

Die im Zusammenhang mit der Spiegelschicht 4 genannten Materialien eignen sich auch für die Reflektorschicht und gegebenenfalls für die weitere Reflektorschicht. Weiterhin können die Kontaktstruktur 6 und die weitere Kontaktstruktur 65 zumindest eine Schicht aufweisen, die ein TCO-Material, etwa ITO oder SnO oder eines der weiter oben genannten TCO-Materialien, enthält.

Ferner weist die Reflektorschicht 61 beziehungsweise die weitere Reflektorschicht 66 vorzugsweise neben einer hohen Reflektivität für im aktiven Bereich erzeugte Strahlung auch gute elektrische Kontakteigenschaften zum Halbleiterkörper 2 auf.

Die Reflektorschicht 61 und/oder die weitere Reflektorschicht 66 ist vorzugsweise dünn im Vergleich zu anderen Schichten der Kontaktstruktur 6 beziehungsweise der weiteren Kontaktstruktur 65. Weiterhin bevorzugt ist die Reflektorschicht 61 und/oder die weitere Reflektorschicht 66 bevorzugt dünn im Vergleich zu der Spiegelschicht 4. Die Dicke der Reflektorschicht 61 beträgt bevorzugt höchstens 200 nm, besonders bevorzugt höchstens 100 nm.

Weitergehend kann die Reflektorschicht und/oder die weitere Reflektorschicht so dünn ausgeführt sein, dass die Dicke höchstens 50 nm, bevorzugt höchstens 20 nm, aufweist. Die so dünn ausgeführte Reflektorschicht und/oder die weitere Reflektorschicht kann für im aktiven Bereich 25 erzeugte Strahlung teiltransparent sein.

Die Spiegelstruktur 3, insbesondere die dielektrische Schichtstruktur 5, setzt sich in lateraler Richtung über die den Halbleiterkörper 2 begrenzende Seitenfläche 26 hinaus eben fort. Hierbei ist die Seitenfläche 26 frei oder im wesentlichen frei von Material für die dielektrische Schichtstruktur. In einer Aufsicht auf den Halbleiterchip verläuft die laterale Begrenzung des Halbleiterkörpers innerhalb der dielektrischen Schichtstruktur 5, insbesondere innerhalb des äußeren Teilbereichs 5B der dielektrischen Schichtstruktur. Im Betrieb des Halbleiterchips kann so eine Injektion von Ladungsträgern in den Halbleiterkörper im Randbereich des Halbleiterkörpers vermieden werden. Der Randbereich des Halbleiterkörpers ist somit elektrisch nicht oder zumindest vergleichsweise wenig aktiv. Gleichzeitig kann mittels der Spiegelstruktur 3 Strahlung, die aus dem Randbereich des Halbleiterkörpers 2 austritt, von der Spiegelstruktur reflektiert werden. Eine Absorption dieser in Richtung des Trägers 7 abgestrahlten Strahlung im Träger kann so vermieden oder zumindest vermindert wird.

Weitergehend erstreckt sich die Spiegelstruktur 3, also die dielektrische Schichtstruktur 5 und die Spiegelschicht 4, lateral umlaufend bis zu einer den Träger 7 in lateraler Richtung begrenzenden Seitenfläche 71. Auf diese Weise kann auch eine Absorption im Träger 7 von im aktiven Bereich erzeugter Strahlung, die aus der Seitenfläche 26 des Halbleiterkörpers in Richtung des Trägers 7 des Halbleiterkörpers abgestrahlt wird, besonders effizient vermieden werden.

Selbstverständlich sind die Kontaktstruktur 6 und gegebenenfalls die weitere Kontaktstruktur 65, insbesondere hinsichtlich ihrer geometrischen Ausbildung, nicht auf die explizit beschriebene Ausführung beschränkt. Vielmehr können die Kontaktstruktur und die weitere Kontaktstruktur beispielsweise einen oder eine Mehrzahl von stegartig ausgebildeten Teilbereichen, die sich beispielsweise über die Strahlungsaustrittsfläche 10 erstrecken können, zur effizienten Einprägung von Ladungsträgern in den Halbleiterkörper 2 aufweisen. Alternativ oder zusätzlich kann die Kontaktstruktur und/oder die weitere Kontaktstruktur auch mehrere separate Teilbereiche aufweisen (jeweils nicht explizit dargestellt).

Die dielektrische Schichtstruktur kann vom in den Figuren 1A und 1B dargestellten Beispiel abweichend auch eine Mehrzahl von Aussparungen aufweisen. Beispielsweise kann die dielektrische Schichtstruktur, insbesondere den stegartig ausgebildeten Teilbereichen der weiteren Kontaktstruktur entsprechend, stegartige Teilbereiche aufweisen. Die dielektrische Schichtstruktur kann hierbei als lateral zusammenhängende Schichtstruktur ausgeführt sein.

Der Halbleiterchip 1 ist als LED-Dünnfilm-Halbleiterchip ausgeführt. Ein Aufwachssubstrat für die Halbleiterschichtenfolge des Halbleiterkörpers 2 ist vollständig entfernt. Die Bauhöhe des Halbleiterchips 1 kann so verringert werden.

Der aktive Bereich 25 ist vorzugsweise zur Erzeugung von Strahlung im infraroten, sichtbaren oder ultravioletten Spektralbereich vorgesehen und enthält besonders bevorzugt ein III-V-Halbleitermaterial. Zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y} As) Spektralbereich sind III-V-Halbleitermaterialien besonders geeignet.

Von dem gezeigten Beispiel abweichend kann der Halbleiterchip 1 auch als RCLED-Halbleiterchip oder als ein Halbleiterlaserchip, etwa als VCSEL oder VECSEL, wie oben näher beschrieben ausgeführt sein.

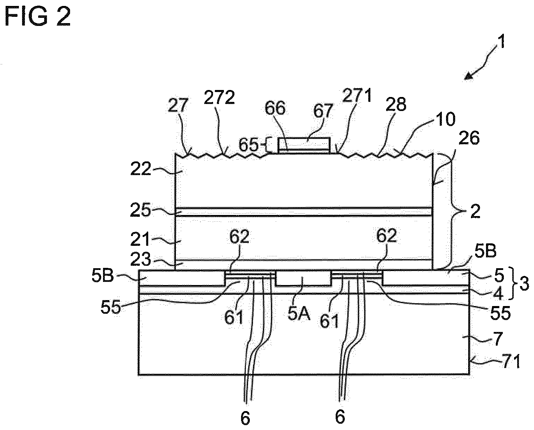

Ein zweites Beispiel für einen Halbleiterchip ist in Figur 2 schematisch in Schnittansicht dargestellt. Hierbei entspricht das zweite Beispiel im Wesentlichen dem im Zusammenhang mit den Figuren 1A und 1B beschriebenen ersten Beispiel. Im Unterschied hierzu weist der Halbleiterkörper 2 eine Oberfläche 27 mit einer Strukturierung 28 auf. Die Oberfläche 27 stellt die Strahlungsaustrittsfläche 10 des Halbleiterchips 1 dar.

Weiterhin ist die Oberfläche 27 in einem in vertikaler Richtung an die weitere Kontaktstruktur 65 angrenzenden Bereich 271 vorzugsweise eben ausgeführt. Insbesondere kann dieser Bereich der Oberfläche 271 geglättet sein. Die Reflektivität der weiteren Kontaktstruktur 65, insbesondere der Reflektorschicht 66, kann so gesteigert werden.

Die Strukturierung 28 ist ein einem lateral an den für die Kontaktstruktur vorgesehenen Bereich 271 lateral angrenzenden weiteren Bereich 272 der Oberfläche 27 ausgebildet. Die Strukturierung ist vorzugsweise derart ausgeführt, dass die Auskoppeleffizienz von im aktiven Bereich 25 erzeugter Strahlung aus dem Halbleiterchip 1 gesteigert ist.

Die Strukturierung 28 kann regelmäßig oder unregelmäßig ausgebildet sein. Eine unregelmäßige Strukturierung kann beispielsweise mechanisch, etwa mittels Aufrauens, hergestellt sein.

Eine regelmäßige Strukturierung 28 der Oberfläche 27 kann beispielsweise mittels Erhebungen und/oder Vertiefungen, etwa in Form von Mikroprismen, oder in Form eines photonischen Gitters ausgeführt sein. Bei einem photonischen Gitter liegt die Periodenlänge der lateralen Strukturierung im Bereich der Wellenlänge der im aktiven Bereich erzeugten Strahlung, bevorzugt zwischen dem 0,1-fachen und dem 10-fachen dieser Wellenlänge in dem Material, in dem das photonische Gitter ausgebildet ist.

Weiterhin weist die Kontaktstruktur 60 eine Schicht 62 auf, die ein TCO-Material enthält oder aus einem TCO-Material besteht. Beispielsweise eignet sich ITO oder SnO. Auch ein anderes binäres oder ternäres TCO-Material kann Anwendung finden. Die TCO-Material enthaltende Schicht 62 ist zwischen dem Halbleiterkörper 2 und der Reflektorschicht 61 angeordnet. Ferner grenzt die TCO-Material enthaltende Schicht 62 an den Halbleiterkörper 2 an.

Der Halbleiterkörper 2 weist auf der der Kontaktstruktur 60 zugewandten Seite eine Tunnelkontaktschicht 23 auf. Die Tunnelkontaktschicht weist eine hohe Dotierkonzentration auf, bevorzugt mindestens 10¹⁸cm⁻³, besonders bevorzugt mindestens 10¹⁹cm⁻³. Die Tunnelkontaktschicht ist n-leitend und damit vom entgegengesetzten Leitungstyp wie die an die Tunnelkontaktschicht 23 angrenzende Halbleiterschicht 21, die p-leitend dotiert ist. Entsprechend ist die Tunnelkontaktschicht für den Fall, dass sie an eine n-leitende Halbleiterschicht angrenzt, p-leitend dotiert.

Mittels der Tunnelkontaktschicht 23 können Ladungsträger vereinfacht in den Halbleiterkörper 2 injiziert werden. Die Tunnelkontaktschicht 23 findet im beispielhaft beschriebenen Fall der elektrisch zu kontaktierenden p-leitenden Halbleiterschicht 21 insbesondere dann Anwendung, wenn die an den Halbleiterkörper 2 angrenzende Schicht der Kontaktstruktur 60, also die TCO-Material enthaltende Schicht 62, zu einer n-leitenden Halbleiterschicht einen besseren elektrischen Kontakt herstellt als zu einer p-leitenden Halbleiterschicht. Abhängig vom Material der Kontaktstruktur 60 kann auf die Tunnelkontaktschicht auch verzichtet werden.

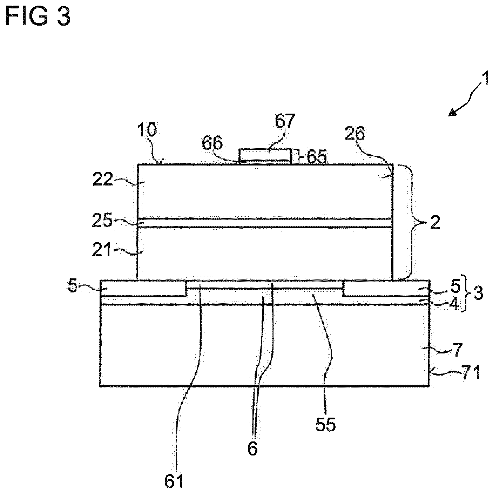

Ein drittes Beispiel für einen Halbleiterchip ist in Figur 3 in einer schematischen Schnittansicht dargestellt. Das dritte Beispiel entspricht im Wesentlichen dem im Zusammenhang mit den Figuren 1A und 1B beschriebenen ersten Beispiel. Im Unterschied zum ersten Beispiel ist die dielektrische Schichtstruktur 5 rahmenartig ausgebildet. Ein innerer Teilbereich, der von einem äußeren Teilbereich beabstandet ist, ist also nicht vorgesehen. Weiterhin weist die dielektrische Schichtstruktur wie in Zusammenhang mit dem ersten Beispiel beschrieben eine Aussparung 55 auf. Die dielektrische Schichtstruktur 5 kann als eine lateral zusammenhängende Schichtstruktur ausgebildet sein. Weiterhin erstreckt sich die dielektrische Schichtstruktur 5, wie der äußere Teilbereich 5B der dielektrischen Schichtstruktur 5 im Zusammenhang mit den Figuren 1A und 1B beschriebenen ersten Beispiel, in Aufsicht auf den Halbleiterchip 1 überwiegend entlang der lateralen Begrenzung des Halbleiterkörpers 2. Die dielektrische Schichtstruktur 5 dient somit vorwiegend der Verminderung von randnaher Injektion von Ladungsträgern in den Halbleiterkörper, wobei die Spiegelstruktur 3, also die dielektrische Schichtstruktur 5 mit der Spiegelschicht 4, in diesem randnahen Bereich gleichzeitig bewirkt, dass eine Absorption von in Richtung des Trägers 7 abgestrahlter Strahlung im Träger vermieden oder zumindest vermindert wird.

Die Kontaktstruktur 6 ist wie im Zusammenhang mit dem ersten Beispiel beschrieben in der Aussparung 55 der dielektrischen Schichtstruktur 5 angeordnet.

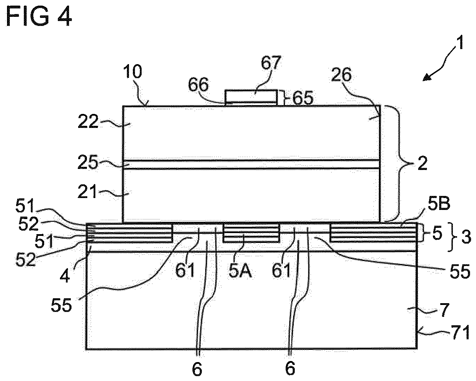

Ein erstes Ausführungsbeispiel für einen erfindungsgemäßen Halbleiterchip ist in Figur 4 anhand einer schematischen Schnittansicht gezeigt. Das erste Ausführungsbeispiel entspricht im Wesentlichen dem im Zusammenhang mit den Figuren 1A und 1B beschriebenen Beispiel. Im Unterschied zum ersten Beispiel ist die dielektrische Schichtstruktur 5 mehrschichtig aufgebaut. Die dielektrische Schichtstruktur umfasst also eine Mehrzahl von dielektrischen Schichten. Mittels der dielektrischen Schichtstruktur ist eine dielektrische Spiegelstruktur gebildet. Die dielektrische Spiegelstruktur umfasst eine Mehrzahl von Schichtpaaren, jeweils bestehend aus einer ersten Schicht 51 und einer zweiten Schicht 52, wobei die erste Schicht und die zweite Schicht voneinander verschiedene Brechungsindizes aufweisen. Die dielektrische Spiegelstruktur ist vorzugsweise als Bragg-Spiegel ausgeführt und weist weiterhin bevorzugt zehn Schichtpaare oder mehr, besonders bevorzugt zwanzig Schichtpaare oder mehr, auf. Je höher die Anzahl der Schichtpaare ist, desto höher kann die Reflektivität der dielektrischen Spiegelstruktur sein. Von der dielektrischen Schichtstruktur 5 transmittierte Strahlung, etwa Strahlung, die in einem vergleichsweise großen Winkel zu einer Normalen der Schichten 51, 52 auf die Schichten auftrifft, kann nachfolgend an der Spiegelschicht 4 in den Halbleiterkörper 2 zurück reflektiert werden. Durch die Kombination der dielektrischen Spiegelstruktur mit der Spiegelschicht kann so auf einfache Weise eine Spiegelstruktur 3 mit hoher Reflektivität für im aktiven Bereich erzeugte Strahlung erzielt werden. Insbesondere kann die Spiegelstruktur 3 aufgrund der der Spiegelschicht 4 vorgelagerten dielektrischen Spiegelstruktur 5 auch bei einer geringeren Reflektivität der Spiegelschicht eine ähnlich hohe Gesamtreflektivität aufweisen.

Eine gemäß diesem Ausführungsbeispiel ausgeführte dielektrische Schichtstruktur 5 mit einer Mehrzahl von dielektrischen Schichten ist selbstverständlich auch in Halbleiterchips einsetzbar, die gemäß den weiter oben oder nachfolgend beschriebenen ausgeführt sind.

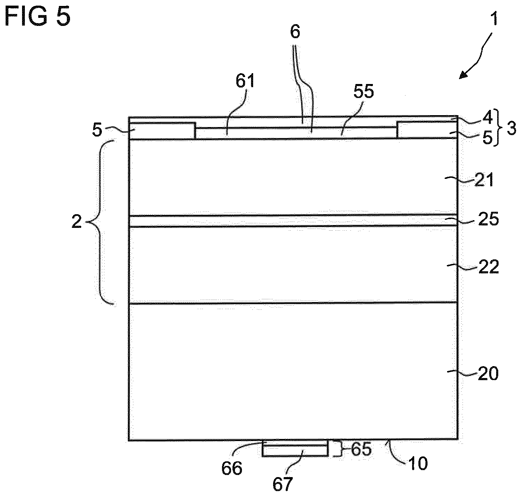

Ein viertes Beispiel für einen Halbleiterchip ist in Figur 5 schematisch in Schnittansicht dargestellt. Das vierte Beispiel entspricht im Wesentlichen dem im Zusammenhang mit den Figuren 1A und 1B beschriebenen ersten Beispiel. Im Unterschied dazu ist ein Aufwachssubstrat 20 für die Halbleiterschichtenfolge des Halbleiterkörpers 2 nicht oder zumindest nicht vollständig entfernt. Das Aufwachssubstrat kann also gedünnt sein. Auf einen zusätzlichen, vom Aufwachssubstrat 20 verschiedenen, Träger kann in diesem Fall verzichtet werden.

Weiterhin ist die Strahlungsaustrittsfläche 10 des Halbleiterchips eine vom Halbleiterkörper 2 abgewandte Oberfläche des Aufwachssubstrats 20. Die Strahlungsaustrittsfläche ist hierbei auf der der Spiegelstruktur 3 abgewandten Seite des aktiven Bereichs 25 ausgebildet.

Die weitere Kontaktstruktur 65 ist auf der dem Halbleiterkörper 2 abgewandten Seite des Aufwachssubstrats 20 angeordnet. In diesem Fall ist das Aufwachssubstrat 20 zweckmäßigerweise elektrisch leitfähig ausgebildet. Bei einem elektrisch nicht leitfähigen Aufwachssubstrat kann alternativ die weitere Kontaktstruktur 65 auf derselben Seite des Halbleiterkörpers 2 angeordnet sein wie die Kontaktstruktur 6. Ein derartiger Halbleiterchip wird auch als Flip-Chip bezeichnet (nicht explizit dargestellt). Als weitere Alternative kann ein, insbesondere elektrisch isolierendes, Aufwachssubstrat bereichsweise entfernt sein, sodass der Halbleiterkörper 2 von der Seite des Aufwachssubstrats 20 her freigelegt ist. In diesem freigelegten Bereich kann dann die weitere Kontaktstruktur 65 angeordnet sein.

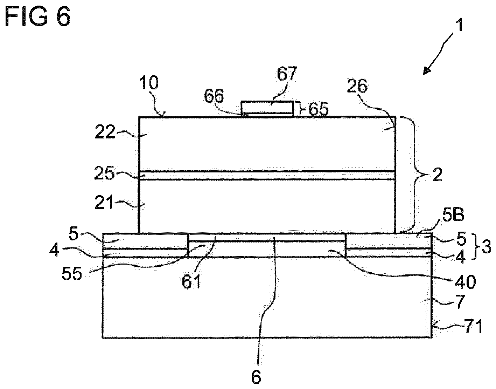

Ein fünftes Beispiel für einen Halbleiterchip ist in Figur 6 schematisch in Schnittansicht dargestellt. Das fünfte Beispiel entspricht im Wesentlichen dem im Zusammenhang mit Figur 3 beschriebenen dritten Beispiel. Im Unterschied dazu weist die Spiegelschicht 4 eine Aussparung 40 auf. Die Aussparung der Spiegelschicht überlappt mit der Aussparung 55 der dielektrischen Schichtstruktur 5 in einer Aufsicht auf den Halbleiterchip 1. Zwischen der Spiegelschicht 4 und dem Halbleiterkörper 2 ist durchgängig die dielektrische Schichtstruktur 5 angeordnet. Weiterhin ist die Spiegelschicht 4 separat von der Kontaktstruktur 6 ausgeführt. Insbesondere ist die Spiegelschicht 4 von der Kontaktstruktur 6 beabstandet. In diesem Fall sind die Spiegelschicht 4 und die Kontaktstruktur 6, insbesondere hinsichtlich der verwendeten Materialien, weitgehend unabhängig voneinander optimierbar.

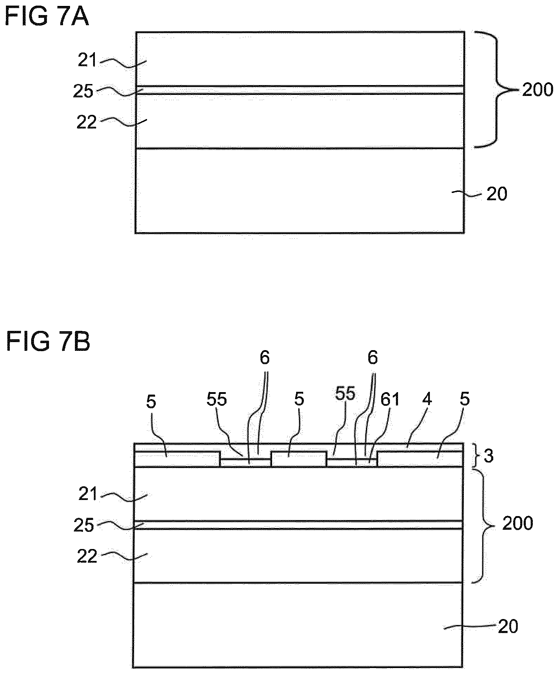

Ein Beispiel für ein Verfahren zur Herstellung eines Halbleiterchips ist anhand der in den Figuren 7A bis 7D schematisch in Schnittansicht dargestellten Zwischenschritte gezeigt. Das Verfahren ist hierbei lediglich beispielhaft für die Herstellung eines Halbleiterchips beschrieben, der gemäß dem ersten Beispiel ausgeführt ist. Das Verfahren ist selbstverständlich auch für die Herstellung anderer Halbleiterchips, insbesondere für die Herstellung von Halbleiterchips gemäß dem ersten Ausführungsbeispiel oder gemäß dem zweiten bis fünften Beispiel geeignet.

Wie in Figur 7A dargestellt, wird zunächst ein Halbleiterschichtstruktursystem 200 mit einem aktiven Bereich 25 bereitgestellt. Hierbei ist in der Figur zur vereinfachten Darstellung lediglich der Ausschnitt des Halbleiterschichtstruktursystems dargestellt, aus dem der Halbleiterkörper eines fertiggestellten Halbleiterchips hervorgeht.

Das Halbleiterschichtstruktursystem 200 wird bevorzugt mittels eines Epitaxie-Verfahrens, etwa MOCVD oder MBE, auf einem Aufwachssubstrat 20 für das Halbleiterschichtstruktursystem abgeschieden. Auf diesem Aufwachssubstrat 20 kann das Halbleiterschichtstruktursystem bereitgestellt werden. Davon abweichend kann das Halbleiterschichtstruktursystem aber auch auf einem Hilfsträger, der vom Aufwachssubstrat verschieden ist, bereitgestellt werden.

Auf der dem Aufwachssubstrat 20 abgewandten Seite des Halbleiterschichtstruktursystems 200 wird eine Spiegelstruktur 3 ausgebildet. Hierfür wird eine dielektrische Schichtstruktur 5 auf dem Halbleiterschichtstruktursystem 200 abgeschieden. Nachfolgend wird eine Spiegelschicht 4 auf dem Halbleiterschichtstruktursystem 200 abgeschieden. Die Spiegelschicht 4 wird vorzugsweise derart lateral strukturiert ausgebildet, dass die Spiegelschicht die dielektrische Schichtstruktur 5 vollständig oder nur bereichsweise überdeckt. Das Abscheiden der dielektrischen Schichtstruktur 5 und der Spiegelschicht 4 erfolgt vorzugsweise mittels Aufdampfens oder Aufsputterns.

Weiterhin wird auf der dem Aufwachssubstrat 20 abgewandten Seite des Halbleiterschichtstruktursystems 200 eine Kontaktstruktur 6 ausgebildet. Insbesondere wird die Kontaktstruktur in einer Aussparung 55 der dielektrischen Schichtstruktur 5 ausgebildet. Die Kontaktstruktur wird mittels einer Reflektorschicht 61 und der Spiegelschicht 4 gebildet. Die Reflektorschicht kann hierbei vor oder nach dem Abscheiden der dielektrischen Schichtstruktur auf dem Halbleiterkörper 2 abgeschieden werden (siehe Figur 7B).

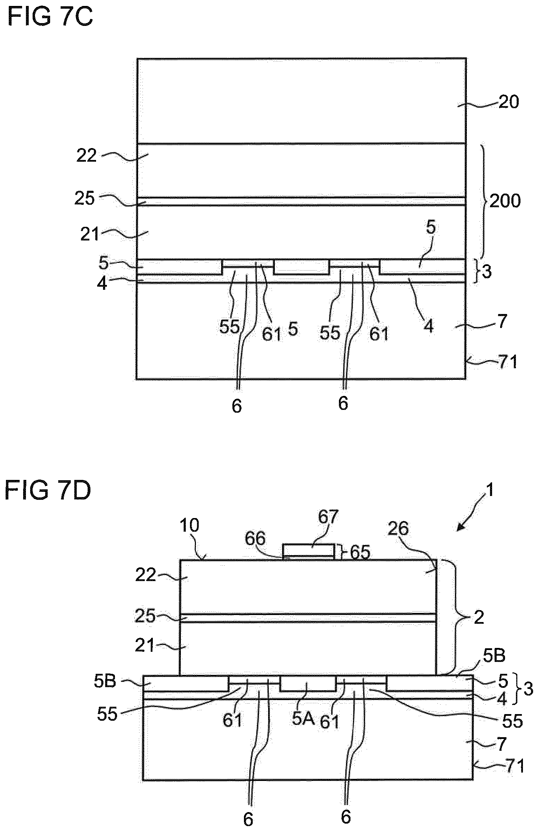

Wie in Figur 7C dargestellt, wird das Halbleiterschichtstruktursystem 200 derart auf einem Träger 7 angeordnet, dass sich die Spiegelstruktur 3 zwischen dem Halbleiterschichtstruktursystem 200 und dem Träger 7 befindet. Eine mechanisch stabile Befestigung des Halbleiterschichtstruktursystems auf dem Träger kann beispielsweise mittels Klebens oder Lötens hergestellt werden. Die so entstehende Verbindungsschicht zwischen dem Träger 7 und dem Halbleiterkörper 2 ist in der Figur nicht explizit dargestellt. Weiterhin bevorzugt wird das Halbleiterschichtstruktursystem in einem Waferbonding-Prozess an dem Träger befestigt.

Davon abweichend kann der Träger 7 auch als eine, vorzugsweise metallische, Schicht auf dem Halbleiterschichtstruktursystem 200 abgeschieden werden. Hierfür eignet sich beispielsweise ein Galvanisierungsverfahren oder ein anderes Abscheideverfahren wie Aufdampfen oder Aufsputtern.

Nachfolgend kann, wie in Figur 7D dargestellt, das Aufwachssubstrat 20 entfernt werden. Das Entfernen des Aufwachssubstrats kann vollständig oder nur bereichsweise erfolgen. Davon abweichend kann das Aufwachssubstrat auch vollständig oder nur bereichsweise gedünnt werden. Für das Entfernen beziehungsweise Dünnen des Aufwachssubstrats eignet sich beispielsweise ein mechanischer Prozess, etwa Schleifen, Polieren oder Läppen, ein chemischer Prozess, etwa nasschemisches oder trockenchemisches Ätzen. Alternativ oder ergänzend kann der Träger mittels eines Laserablöseverfahrens entfernt werden.

Aus dem Halbleiterschichtstruktursystem 200 wird der Halbleiterkörper 2 ausgebildet. Das Ausbilden des Halbleiterkörpers 2 erfolgt vorzugsweise mittels Abtragens von Material für das Halbleiterschichtstruktursystem 200. Dies kann beispielsweise mittels nasschemischen oder trockenchemischen Ätzens erfolgen. Vorzugsweise wird der Halbleiterkörper 2 aus dem Halbleiterschichtstruktursystem 200 ausgebildet, nachdem das Aufwachssubstrat entfernt oder gedünnt ist.

Das Entfernen des Halbleitermaterials des Halbleiterschichtstruktursystems 200 erfolgt von der dem Träger 7 abgewandten Seite des Halbleiterschichtstruktursystems her. Durch das Entfernen des epitaxierten Halbleitermaterials des Halbleiterschichtstruktursystems 200 wird die Spiegelstruktur 3, insbesondere die dielektrische Schichtstruktur 5, bereichsweise freigelegt. Davon abweichend kann die Spiegelstruktur auch vollständig durchtrennt werden. In diesem Fall kann das Abtragen von Material fortgeführt werden, bis der Träger 7 bereichsweise freigelegt wird. Zum Fertigstellen des Halbleiterchips 1 wird auf der der Spiegelstruktur 3 abgewandten Seite des Halbleiterkörpers 2 eine weitere Kontaktstruktur 65 ausgebildet. Das Ausbilden der weiteren Kontaktstruktur erfolgt vorzugsweise nach dem Ausbilden des Halbleiterkörpers 2 aus dem Halbleiterschichtstruktursystem 200.

Vorzugsweise wird bei dem Verfahren, insbesondere gleichzeitig, eine Mehrzahl von Halbleiterchips 1 hergestellt, wobei die Halbleiterkörper 2 der jeweiligen Halbleiterchips jeweils aus lateral nebeneinander angeordneten Teilbereichen des Halbleiterschichtstruktursystems 200 hervorgehen.

Die Erfindung ist nicht durch die Beschreibung anhand der Ausführungsbeispiele beschränkt.

## Patentansprüche

1. Halbleiterchip (1) mit einem Halbleiterkörper (2), der eine Halbleiterschichtenfolge mit einem zur Erzeugung von Strahlung vorgesehenen aktiven Bereich (25) umfasst, wobei
- auf dem Halbleiterkörper (2) eine Spiegelstruktur (3), die eine Spiegelschicht (4) und eine zumindest bereichsweise zwischen der Spiegelschicht (4) und dem Halbleiterkörper (2) angeordnete dielektrische Schichtstruktur (5) aufweist, angeordnet ist;
- mittels der dielektrischen Schichtstruktur (5) eine dielektrische Spiegelstruktur gebildet ist, die eine Mehrzahl von Schichtpaaren, die jeweils aus einer ersten Schicht (51) und einer zweiten Schicht (52) bestehen, umfasst, wobei die erste Schicht und die zweite Schicht voneinander verschiedene Brechungsindizes aufweisen;
- die dielektrische Schichtstruktur (5) eine Aussparung (55) aufweist; und
- auf dem Halbleiterkörper (2) eine Kontaktstruktur (6) angeordnet ist, die in der zumindest einen Aussparung (55) der dielektrischen Schichtstruktur (5) angeordnet ist.

2. Halbleiterchip nach Anspruch 1,
bei dem die dielektrische Spiegelstruktur als Bragg-Spiegel ausgebildet ist.

3. Halbleiterchip nach Anspruch 1 oder 2,
bei dem der Halbleiterkörper (2) eine Seitenfläche (26) aufweist, die den Halbleiterkörper (2) in lateraler Richtung begrenzt und bei dem sich die dielektrische Schichtstruktur (5) in lateraler Richtung zumindest bereichsweise über die den Halbleiterkörper (2) begrenzende Seitenfläche (26) hinaus fortsetzt.

4. Halbleiterchip nach einem der Ansprüche 1 bis 3,
bei dem die dielektrische Schichtstruktur (5) mittels der Aussparung (55) in zumindest zwei separate Teilbereiche (5A, 5B) geteilt ist.

5. Halbleiterchip nach einem der Ansprüche 1 bis 4,
bei dem die Kontaktstruktur (6) mehrschichtig ausgebildet ist.

6. Halbleiterchip nach Anspruch 5,
bei dem die Kontaktstruktur (6) eine TCO-Material enthaltende Schicht (62) aufweist.

7. Halbleiterchip nach Anspruch 6,
bei dem die Kontaktstruktur (6) eine Reflektorschicht (61) aufweist, die ein Metall oder eine metallische Legierung enthält und die näher am Halbleiterkörper (2) angeordnet ist als die Spiegelschicht (4), wobei die TCO-Material enthaltende Schicht (62) der Kontaktstruktur (6) zwischen dem Halbleiterkörper (2) und der Reflektorschicht (61) angeordnet ist.

8. Halbleiterchip nach einem der Ansprüche 1 bis 7,
bei dem eine weitere Kontaktstruktur (65) auf der der Kontaktstruktur (6) abgewandten Seite des aktiven Bereichs (25) auf einer Oberfläche (27) des Halbleiterkörpers (2) angeordnet ist, wobei die Oberfläche (27) in einem an die weitere Kontaktstruktur (65) lateral angrenzenden Bereich (271) eben ist und in einem an den ebenen Bereich der Oberfläche (27) angrenzenden weiteren Bereich (272) eine Strukturierung (28) aufweist.

9. Halbleiterchip nach einem der vorhergehenden Ansprüche,
bei dem der Halbleiterchip einen Träger (7) aufweist, wobei die dielektrische Schichtstruktur (5) zwischen dem Halbleiterkörper (2) und dem Träger (7) angeordnet ist.

10. Halbleiterchip nach Anspruch 1,
bei dem der Halbleiterchip (1) einen Träger (7), auf dem der Halbleiterkörper (2) angeordnet ist, aufweist, und bei dem die dielektrische Schichtstruktur (5)
- zwischen dem Träger (7) und dem Halbleiterkörper (2) angeordnet ist,
- sich in lateraler Richtung zumindest bereichsweise über eine den Halbleiterkörper (2) in lateraler Richtung begrenzende Seitenfläche (26) des Halbleiterkörpers (2) hinaus fortsetzt, und
- die dielektrische Schichtstruktur (5) mittels der Aussparung (55) in zumindest zwei separate Teilbereiche (5A, 5B) geteilt ist.

11. Halbleiterchip nach Anspruch 1,
bei dem die dielektrische Schichtstruktur (5) mittels der Aussparung (55) in einen inneren Teilbereich (5A) und einen äußeren Teilbereich (5B) geteilt ist, wobei
- auf der der Kontaktstruktur (6) abgewandten Seite des aktiven Bereichs (25) eine weitere Kontaktstruktur (65) auf dem Halbleiterkörper angeordnet ist, und
- der innere Teilbereich (5A) in Aufsicht auf den Halbleiterchip mit der weiteren Kontaktstruktur (65) überlappt.

12. Halbleiterchip nach einem der vorhergehenden Ansprüche, der als LED-Chip, RCLED-Chip der als Halbleiterlaser-Chip ausgeführt ist.

13. Verfahren zur Herstellung eines Halbleiterchips (1) mit einem Halbleiterkörper (2), der eine Halbleiterschichtenfolge mit einem zur Erzeugung von Strahlung vorgesehenen aktiven Bereich (25) umfasst, mit den Schritten:
a) Bereitstellen eines Halbleiterschichtstruktursystems (200) mit dem aktiven Bereich (25),
b) Ausbilden einer Spiegelstruktur (3) auf dem Halbleiterschichtstruktursystem(200), wobei die Spiegelstruktur (3) eine dielektrische Schichtstruktur (5) und eine Spiegelschicht (4) umfasst, wobei
- mittels der dielektrischen Schichtstruktur (5) eine dielektrische Spiegelstruktur gebildet ist, die eine Mehrzahl von Schichtpaaren, die jeweils aus einer ersten Schicht (51) und einer zweiten Schicht (52) bestehen, umfasst, wobei die erste Schicht und die zweite Schicht voneinander verschiedene Brechungsindizes aufweisen;
- die dielektrische Schichtstruktur (5) eine Aussparung (55) aufweist; und
- auf dem Halbleiterkörper (2) eine Kontaktstruktur (6) angeordnet ist, die in der zumindest einen Aussparung (55) der dielektrischen Schichtstruktur (5) angeordnet ist;
c) Ausbilden des Halbleiterkörpers (2) mit der Halbleiterschichtenfolge aus dem Halbleiterschichtstruktursystem (200), und
d) Fertigstellen des Halbleiterchips (1).

14. Verfahren nach Anspruch 13,
bei dem eine Oberfläche (27) des Halbleiterkörpers (2) zumindest bereichsweise chemisch und/oder mechanisch geglättet wird, wobei die Kontaktstruktur (6) und/oder die weitere Kontaktstruktur (65) auf dem geglätteten Bereich (271) der Oberfläche (27) ausgebildet werden.

## Claims

1. Semiconductor chip (1) with a semiconductor body (2) comprising a semiconductor layer sequence with an active region (25) provided for generating radiation, wherein
- a mirror structure (3) is arranged on the semiconductor body (2) said mirror structure (3) comprising a mirror layer (4) and a dielectric layer structure (5) that is arranged at least in regions between the mirror layer (4) and the semiconductor body (2);
- by means of the dielectric layer structure (5) a dielectric mirror structure is formed, which comprises a plurality of layer pairs each consisting of a first layer (51) and a second layer (52), wherein the first layer and the second layer have refractive indices that are different from one another;
- the dielectric layer structure (5) has a cutout (55); and
- a contact structure (6) is arranged on the semiconductor body (2), where the contact structure (6) is arranged in the at least one cutout (55) of the dielectric layer structure (5) .

2. Semiconductor chip according to claim 1,
in which the dielectric mirror structure is formed as a Bragg mirror.

3. Semiconductor chip according to claim 1 or 2,
in which the semiconductor body (2) has a side face (26) that bounds the semiconductor body (2) in a lateral direction and in which the dielectric layer structure (5) extends in the lateral direction at least in regions beyond the side face (26) that bounds the semiconductor body (2).

4. Semiconductor chip according to one of claims 1 to 3,
in which the dielectric layer structure (5) is divided into at least two separate subregions (5A, 5B) by means of the cutout (55) .

5. Semiconductor chip according to one of claims 1 to 4,
in which the contact structure (6) is formed with multiple layers.

6. Semiconductor chip according to claim 5,
in which the contact structure (6) comprises a layer (62) containing a TCO material.

7. Semiconductor chip according to claim 6,
in which the contact structure (6) comprises a reflector layer (61) that contains a metal or a metallic alloy and that is arranged closer to semiconductor body (2) than is the mirror layer (4), wherein the layer (62) that contains a TCO material of the contact structure (6) is arranged between the semiconductor body (2) and the reflector layer (61).

8. Semiconductor chip according to one of claims 1 to 7,
in which a further contact structure (65) is arranged, on a side of the active region (25) facing away from the contact structure (6), on a surface (27) of the semiconductor body (2), wherein the surface (27) is flat in a region (271) laterally adjoining the further contact structure (65), and has a structuring (28) in a further region (272) adjoining the flat region of the surface (27).

9. Semiconductor chip according to one of the preceding claims,
in which the semiconductor chip comprises a carrier (7), wherein the dielectric layer structure (5) is arranged between the semiconductor body (2) and the carrier (7).

10. Semiconductor chip according to claim 1,
in which the semiconductor chip (1) comprises a carrier (7) on which the semiconductor body (2) is arranged, and in which the dielectric layer structure (5)
- is arranged between the carrier (7) and the semiconductor body (2),
- extends in a lateral direction at least in regions beyond a side face (26) of the semiconductor body (2) that bounds the semiconductor body (2) in the lateral direction, and
- the dielectric layer structure (5) is divided into at least two separate subregions (5A, 5B) by means of the cutout (55).

11. Semiconductor chip according to claim 1,
in which the dielectric layer structure (5) is divided by means of the cutout (55) into an inner subregion (5A) and an outer subregion (5B), wherein
- a further contact structure (65) is arranged on the semiconductor body on a side of the active region (25) facing away from the contact structure (6), and
- the inner subregion (5A) overlaps the further contact structure (65) in a plan view onto the semiconductor chip.

12. Semiconductor chip according to one of the preceding claims,
which is embodied as an LED chip, an RCLED chip or as a semiconductor laser chip.

13. Method for manufacturing a semiconductor chip (1) with a semiconductor body (2) comprising a semiconductor layer sequence with an active region (25) provided for generating radiation, with the following steps:
a) providing a semiconductor layer structure system (200) with the active region (25),
b) forming a mirror structure (3) on the semiconductor layer structure system (200) wherein the mirror structure (3) comprises a dielectric layer structure (5) and a mirror layer (4), wherein
- by means of the dielectric layer structure (5) a dielectric mirror structure is formed, which comprises a plurality of layer pairs each consisting of a first layer (51) and a second layer (52), wherein the first layer and the second layer have refractive indices that are different from one another;
- the dielectric layer structure (5) has a cutout (55); and
- a contact structure (6) is arranged on the semiconductor body (2), where the contact structure (6) is arranged in the at least one cutout (55) of the dielectric layer structure (5) ;
c) forming the semiconductor body (2) with the layer sequence from the semiconductor layer structure system (200), and
d) finishing the semiconductor chip (1).

14. Method according to claim 13,
in which a surface (27) of the semiconductor body (2) is smoothed chemically and/or mechanically at least in regions, wherein the contact structure (6) and/or the further contact structure (65) are formed on the smoothed area (271) of the surface (27).

## Revendications

1. Puce électronique à semiconducteur (1) avec un corps de semiconducteur (2), qui comporte une succession de couches semiconductrices avec une zone active prévue (25) en vue de la génération de rayonnement, sachant que
- sur le corps de semiconducteur (2) est disposée une structure à miroir (3), qui présente une couche réfléchissante (4) et une structure stratifiée diélectrique (5) disposée au moins par zones entre la couche réfléchissante (4) et le corps de semiconducteur (2) ;
- au moyen de la structure stratifiée diélectrique (5) est constituée une structure à miroir diélectrique, qui comporte une pluralité de paires de couches, qui sont constituées respectivement d'une première couche (51) et d'une seconde couche (52), sachant que la première couche et la seconde couche présentent des indices de réfraction différents l'un de l'autre ;
- la structure stratifiée diélectrique (5) présente un évidement (55) ; et
- sur le corps de semiconducteur (2) est disposée une structure de contact (6), qui est disposée dans au moins l'un des évidements (55) de la structure stratifiée diélectrique (5).

2. Puce électronique à semiconducteur selon la revendication 1, pour laquelle la structure à miroir diélectrique est constituée comme miroir de Bragg.

3. Puce électronique à semiconducteur selon les revendications 1 ou 2,
pour laquelle le corps de semiconducteur (2) présente une surface latérale (26), qui limite le corps de semiconducteur (2) dans la direction latérale et pour laquelle la structure stratifiée diélectrique (5) se poursuit dans la direction latérale au moins par zones au-delà de la surface latérale (26) limitant le corps de semiconducteur (2).

4. Puce électronique à semiconducteur selon une quelconque des revendications 1 à 3,
pour laquelle la structure stratifiée diélectrique (5) est divisée au moyen de l'évidement (55) en au moins deux zones partielles séparées (5A, 5B).

5. Puce électronique à semiconducteur selon une quelconque des revendications 1 à 4,
pour laquelle la structure de contact (6) est constituée de plusieurs couches.

6. Puce électronique à semiconducteur selon la revendication 5,
pour laquelle la structure de contact (6) présente une couche (62) contenant de la matière TCO.

7. Puce électronique à semiconducteur selon la revendication 6,
pour laquelle la structure de contact (6) présente une couche de réflecteur (61), qui contient un métal ou un alliage métallique et est disposée plus près du corps de semiconducteur (2) que la couche réfléchissante (4), sachant que la couche (62) contenant de la matière TCO de la structure de contact (6) est disposée entre le corps de semiconducteur (2) et la couche de réflecteur (61).

8. Puce électronique à semiconducteur selon une quelconque des revendications 1 à 7,
pour laquelle une autre structure de contact (65) est disposée sur le côté de la zone active (25) détourné de la structure de contact (6) sur une surface (27) du corps de semiconducteur (2), sachant que la surface (27) est plane dans une zone adjacente latéralement (271) à l'autre structure de contact (65) et présente une structuration (28) dans une autre zone adjacente (272) à la surface plane de la surface (27).

9. Puce électronique à semiconducteur selon une quelconque des revendications précédentes,
pour laquelle la puce électronique à semiconducteur présente un support (7), sachant que la structure stratifiée diélectrique (5) est disposée entre le corps de semiconducteur (2) et le support (7).

10. Puce électronique à semiconducteur selon la revendication 1,
pour laquelle la puce électronique à semiconducteur présente un support (7), sur lequel est disposé le corps de semiconducteur (2), et pour laquelle la structure stratifiée diélectrique (5)
- est disposée entre le support (7) et le corps de semiconducteur (2),
- se poursuit dans la direction latérale au moins par zones au-delà d'une surface latérale (26) du corps de semiconducteur (2) limitant le corps de semiconducteur (2) dans la direction latérale, et
- la structure stratifiée diélectrique (5) est divisée au moyen de l'évidement (55) en au moins deux zones partielles séparées (5A, 5B).

11. Puce électronique à semiconducteur selon la revendication 1,
pour laquelle la structure stratifiée diélectrique (5) est divisée au moyen de l'évidement (55) en une zone partielle interne (5A) et une zone partielle externe (5B), sachant que
- sur le côté de la zone active (25) détourné de la structure de contact (6) est disposée une autre structure de contact (65) sur le corps de semiconducteur, et
- la zone partielle interne (5A) se superpose avec l'autre structure de contact (65) en vue de dessus sur la puce électronique à semiconducteur.

12. Puce électronique à semiconducteur selon une quelconque des revendications précédentes,
qui est réalisée comme puce électronique à LED, comme puce électronique à RCLED ou comme puce électronique laser à semiconducteur.

13. Procédé en vue de la fabrication d'une puce électronique à semiconducteur (1) avec un corps de semiconducteur (2), qui comporte une succession de couches semiconductrices avec une zone active (25) prévue en vue de la génération de rayonnement, avec les étapes de :
a) disposition d'un système à structure stratifiée semiconductrice (200) avec la zone active (25),
b) constitution d'une structure à miroir (3) sur le système de structure à couches semiconductrices (200), sachant que la structure à miroir (3) comporte une structure stratifiée diélectrique (5) et une couche réfléchissante (4), sachant que,
- au moyen de la structure stratifiée diélectrique (5) est constituée une structure à miroir diélectrique, qui comporte une pluralité de paires de couches, qui sont constituées respectivement d'une première couche (51) et d'une seconde couche (52), sachant que la première couche et la seconde couche présentent des indices de réfraction différents l'un de l'autre ;
- la structure stratifiée diélectrique (5) présente un évidement (55) ; et
- sur le corps de semiconducteur (2) est disposée une structure de contact (6), qui est disposée dans au moins l'un des évidements (55) de la structure stratifiée diélectrique (5) ;
c) constitution du corps de semiconducteur (2) avec la succession de couches semiconductrices issue du système de structure à couches semiconductrices (200), et
d) achèvement de la puce électronique à semiconducteur (1).

14. Procédé selon la revendication 13,
pour lequel une surface (27) du corps de semiconducteur (2) est lissée chimiquement et/ou mécaniquement au moins par zones, sachant que la structure de contact (6) et/ou l'autre structure de contact (65) sont constituées sur la zone lissée (271) de la surface (27).
